# EUROPEAN PATENT SPECIFICATION

(11) **EP 1 608 013 B1**
(45) Date of publication and mention of the grant of the patent: **24.04.2013**
(21) Application number: 04447220.7
(22) Date of filing: 30.09.2004
(51) Int. Cl.: H01L 21/768

(54) **Method of formation of airgaps around interconnecting line**
Herstellung von mit Luft gefüllten Lücken um eine Verbindungsleitung herum
Méthode de formation de cavités remplies d'air autour d'une ligne d'interconnexion

(30) Priority: 30.09.2003 US 507584; 30.09.2003 EP 03447239
(43) Date of publication of application: 21.12.2005
(73) Proprietor: IMEC, 3001 Leuven (BE)
(72) Inventor: Gueneau de Mussy, Jean Paul, 1050 Elsene (BE); Beyer, Gerald, 3001 Leuven (BE); Maex, Karen, 3020 Herent (BE)
(74) Representative: Van Malderen, Joëlle

(56) References cited:
- EP-A2- 0 725 440
- US-A1- 2002 055 243
- US-A1- 2002 127 844
- US-B1- 6 387 818
- US-B1- 6 403 461
- US-B1- 6 599 814

## Description

### Field of the invention

The present invention is related to the field of semiconductor processing.

More specifically it is related to the production of micro and nano-electromechanical systems (MEMS, NEMS) and to the production of low dielectric isolation for interconnects.

The present invention contributes to the exploration of the field of airgaps integration in semiconductor devices.

### Background of the invention

The use of airgaps in semiconductor devices is known. Airgaps in the form of cavities can typically be present in MEMS and NEMS devices. Those airgaps can structurally be part of such a device or can have a functional role.

Airgaps are considered to be very promising in the technology of interconnects, where they can be used as dielectric for isolation of interconnects. As IC technology scales down, the interconnect is becoming the most important restricting factor in terms of propagation delay, dynamic power consumption and signal errors originated by cross-talk effects between adjacent metal lines. The refocus from aluminium to copper has given an important reduction in the resistance of wired connections on the chip. At the moment, the aim is to achieve better isolation between the lines by introducing materials with lower dielectric constant than that of silicon oxide (k=4.2) leading to reducing the capacitance (C). The integration of low-k materials (k<3.0) into production processes creates a number of challenges associated with leakage, mechanical instability and joule heating, increasing the overall cost of future IC processes.

Additionally, the barrier and intermediate layers tend to increase the effective permittivity of the final stack. Due to the aforementioned problems, and also because air is the best insulator available, a strong incentive exists to integrating airgaps between adjacent metal lines.

The use of air as a dielectric to isolate electrical interconnects is known to reduce RC delay as well as dynamic power consumption and signal errors (e.g. cross-talk).

Different ways of inducing air cavities are known in the art, for instance:
(i) Isotropic Etching (for MEMS applications): consists of using HF for dissolving a sacrificial SiO₂ layer, where other non-reacting film (i.e. SiC) is employed as an etch stop. The etch source is then sealed by a non-conformal CVD SiO₂ layer.
(ii) Anisotropic Etching: this consists of eliminating material by anisotropic dry etch, it is then necessary having a dedicated mask and adding the subsequent dry etch and strip operations. Subsequently a conformal CVD SiO₂ followed by a non-conformal CVD SiO₂ film are deposited on top of the lines responsible for the creation of airgaps.

In US 6,268,261 a process for manufacturing a semiconductor circuit comprising airgaps is disclosed. The process comprises the steps of creating a plurality of adjacent conductive lines having a solid fill between the conductive lines; creating one or more layers above the lines and the fill; creating one or more pathways to the fill through the layers; and converting the fill to a gas that escapes through the pathways, leaving an air void between adjacent lines. The process results in a multi-layer semiconductor circuit comprising conductive lines, wherein the lines have air as a dielectric between them. Here a solid fill needs to be deposited inside between the conductive lines. This fill has to be stable during deposition of the layers on top. In the layers on top a pathway needs to be foreseen, which requires additional processing such as extra masking and etching steps.

In US patent 6,599,814 a method is disclosed for removal of silicon carbide layers and in particular amorphous SiC of a substrate. Initially, the exposed part of a carbide-silicon layer is at least partly converted into an oxide-silicon layer by exposing the carbide-silicon layer to an oxygen containing plasma. The oxide-silicon layer is then removed from the substrate.

### Aim of the invention

It is an aim of the invention to provide a method, which allows to selectively introduce air between narrowly spaced adjacent metal lines.

It is further an aim of the present invention to provide such a method, which is substantially scaling invariant.

It is also an aim of the present invention to provide a method, which comprises a small number of process steps, compared to other state-of the art methods. More specifically it is an aim of the present invention to provide a process that does not introduce extra masking/stripping steps.

### Summary of the invention

The present invention provides a method for making airgaps (4) in a stack of layers of a semiconductor device, said stack of layers comprising:
- a hardmask layer of liner material (2) resistant to a first etching composition, and
- a layer of dielectric or insulator material (3) etchable by said first etching (substance or) composition, under the hardmask layer, said method comprising the steps of:
   a) etching at least one hole in said stack of layers with a second etching composition,
   b) chemically converting a part of said liner material (2), locally, directly adjacent to said hole, into a material (7) that is etchable by said first etching substance and having in plane dimensions smaller than 1 µm,
   c) creating in said hole(s) a line (1) made of a conductive material, said line (1) being resistant to said first etching substance,
   d) etching said dielectric or insulator material (3) and the converted material by contacting said first etching substance with said stack of layers whereby airgaps (4) are created around said line (1).

In a method according to the invention, said sacrificial material (3) is preferably between two layers of said liner material (2).

Preferably, step (c) of a method of the invention comprises the steps of:
- depositing a barrier layer,
- depositing on top of said barrier layer a layer of an electrically conductive material,
- removing on top of said stack of layers the overburden of said electrically conductive material and of said barrier layer.

Said step (a) of etching at least one hole and said step (b) of converting said liner material (2) are simultaneous (are performed at the same time).

Preferably, said conductive material is selected from the group of consisting of metals, carbon nanotubes, and conducting polymers. A metallic conductive material can be copper (Cu), gold (Au) or silver (Ag).

In a method of the invention, said stack of layers can further comprise a basis layer (9), which can be resistant to said first etching composition, and/or resistant to said second etching composition.

Said basis layer (9) can comprise an embedded metal line.

In a method of the invention, the chemically converted part of said liner layers (7) have in-plane dimensions smaller than 500 nm, smaller than 100 nm, or smaller than 10 nm.

In a method of the invention, said dielectric material (3) is preferably silicon dioxide (SiO2).

Said liner layer material is preferably silicon carbide (SiC).

Said second etching substance or composition is preferably a dry etch plasma comprising O₂, which may further comprise at least one (hydro)fluorocarbon compound, e.g. CF₄, CHF₃, and C₄F₈.

Said first etching substance or composition preferably comprises or consists of hydrofluoric acid (HF), e.g. in a concentration of 49 wt.%.

Said first etching substance or composition comprising or consisting of HF can be in vapour form.

In a method of the invention, said stack of layers can be a single or dual damascene stack.

In an embodiment of the invention, said method is carried out at the back end of line, (BEOL) processing.

In a method of the invention, said embedded metal line in said basis layer (9) and said metal line (1) are forming an electrical contact.

The present invention also provides a method for fabricating a semiconductor device having airgaps.

The present invention also provides a method for the production of airgaps in a semiconductor device by repeating the steps of:
- applying a method according to the invention as described herein,
- creating a next stack of layers as described herein on top of the airgap structure resulting from the preceding step.

### Short description of the figures

All drawings are intended to illustrate some aspects and embodiments of the present invention. Devices are depicted in a simplified way for reason of clarity. Not all alternatives and options are shown and therefore the invention is not limited to the content of the given drawings. Like numerals are employed to reference like parts in the different figures.

Figure 1 is a schematic representing a standard Cu single damascene (SD) stack before (a) and after (b) etch of material between narrowly spaced interconnects (1). Typical interconnects are metals (ie. Cu, Au, Ag...) embedded in a (3) SiO₂ and (2) SiC stack. (4) are selectively incorporated airgaps.

Figure 2 (a) is a schematic representing the starting stack after resist coating and deep ultra violet (DUV) patterning (5).

Figure 2 (b) shows the stack (a) after undergoing oxygen containing plasma exposure leading to a local oxidation of the SiC layer (7).

Figure 2 (c) is the former stack after barrier deposition (ie. Ta/TaN (10/15 nm), Cu seed layer deposition (100 nm), Cu electroplating (1 µm) and chemical mechanical polishing (CMP).

Figure 2 (d) is after vapour HF (VHF) exposure (8) generating air cavities near the SiO₂/TaN interface.

Figure 2 (e) is after a thick conformal CVD layer (ie. SiC/SiO₂ CVD) has been deposited on top.

Figure 3 (a) is a schematic representing the starting stack after resist coating and deep ultra violet (DUV) patterning (5). (9) is a CVD or spin on material resistant to HF exposure (ie. Silicon oxycarbide SiCOH).

Indeed, layer (9), also referred to as the basis layer, is preferably resistant to the second etching substance, this way the etching of the hole in the stack of layers is downwards limited by the basis layer.

The basis layer is also preferably resistant to the first etching substance limiting the creation of airgaps. Preferably no airgap is formed in the basis layer (9).

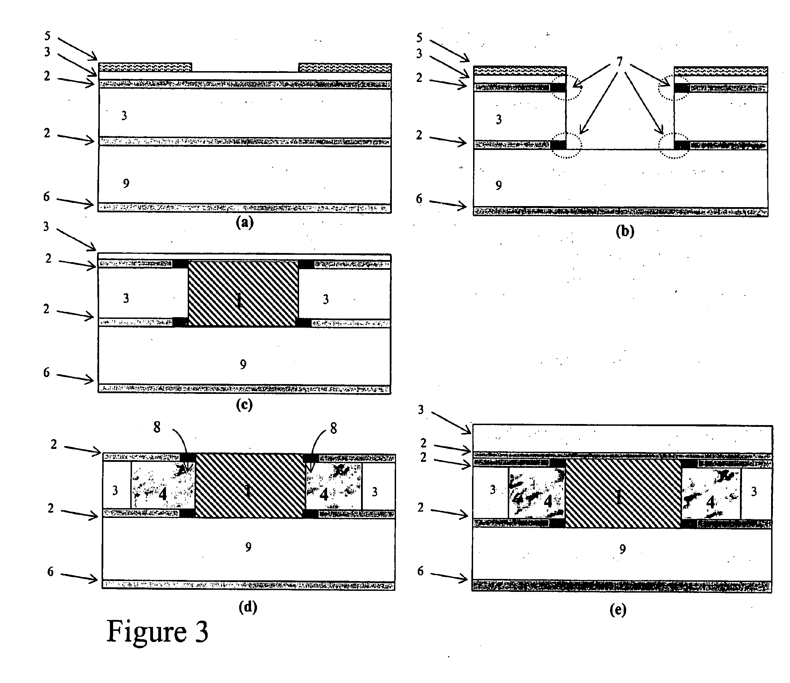

Figure 3 (b) shows the stack (a) after undergoing oxygen containing plasma exposure leading to a local oxidation of the SiC layer (7).

Figure 3 (c) is the former stack after barrier deposition (i.e. Ta/TaN (10/15 nm), Cu seed layer deposition (100 nm), Cu electroplating (1 µm) and chemical mechanical polishing (CMP).

Figure 3 (d) is after VHF exposure (8) generating air cavities near the SiO₂/TaN interface. Note that the underlying material is not etched by HF, which is intended to confine the airgap cavities to a single level.

Figure 3 (e) is after a thick conformal CVD layer (ie. SiC/SiO₂ CVD) has been deposited on top.

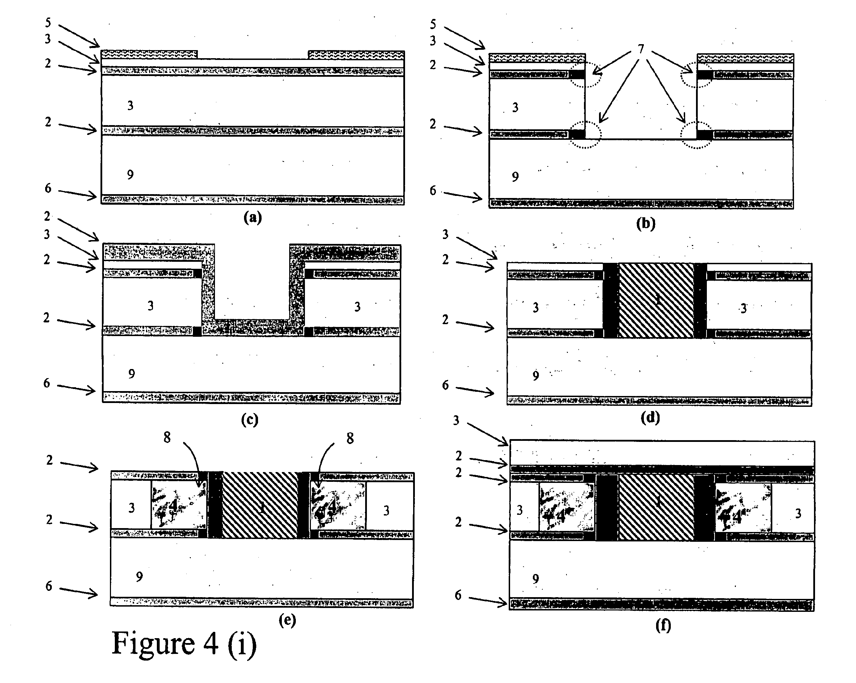

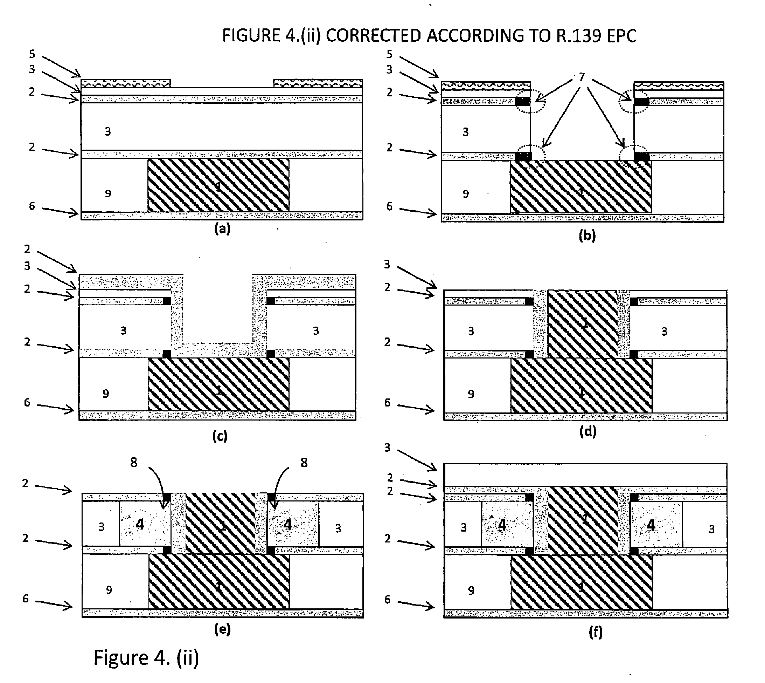

Figure 3 and Fig. 4 differ in the fact that an extra SiC layer(2) is deposited after etching the opening in the SiO₂ material. After deposition of said extra SiC layer, the bottom of said extra SiC layer is opened by etching and subsequent a barrier layer (i.e. Ta/TaN (10/15 nm) and a Cu seed layer (100 nm) are deposited prior to Cu electroplating (1 µm) and chemical mechanical polishing (CMP).

Figure 4i and Figure 4ii differ in the fact that the basis layer (9) comprises further a metal structure. This metal structure is preferably making contact with the conductive line created in the hole etched in sacrificial layer (3). Finally this structure will lead to a damascene structure.

Figure 4 (a) is a schematic representing the starting stack after resist coating and deep ultra violet (DUV) patterning (5).

Figure 4 (b) shows the stack (a) after a dry etch operation in an O₂ containing plasma.

Figure 4 (c) is the former stack after an extra SiC layer (i.e. 50 nm) has been deposited.

Figure 4 (d) is after an isotropic oxygen plasma treatment with the aim of opening the bottom of the SiC layer. In figure 4i the etching of the hole is stopped on the basis layer (9), in Figure 4ii the etching of the hole is stopped on the metal structure embedded in the basis layer (9).

Figure 4 (e) is after deposition of a barrier (ie. Ta/TaN (10/15 nm), Cu seed layer deposition (100 nm) and Cu electroplating (1 µm) followed by (CMP) and HF vapour exposure, generating air cavities (4).

Figure 4 (f) is after a thick conformal CVD layer (ie. SiC/SiO₂ CVD) has been deposited on top of the air cavities (4).

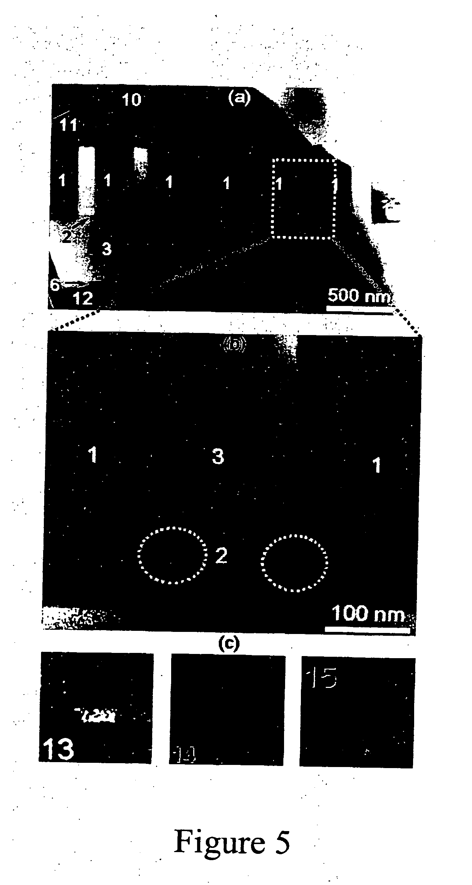

Figure 5 is a cross-sectional TEM image of the Cu/SiO₂ single damascene stack at low (a) and high (b) magnification, (10) and (11) correspond to protective platinum and glass layers respectively. (12) refers to the Si substrate. (c) correspond to C (13), Cu (14) and O (15) EFTEM mappings of the area surrounded by the white dotted square on (a). Note that in EFTEM analysis light zones refer to high element concentrations. The white dotted circles denote converted SiC regions (plugs).

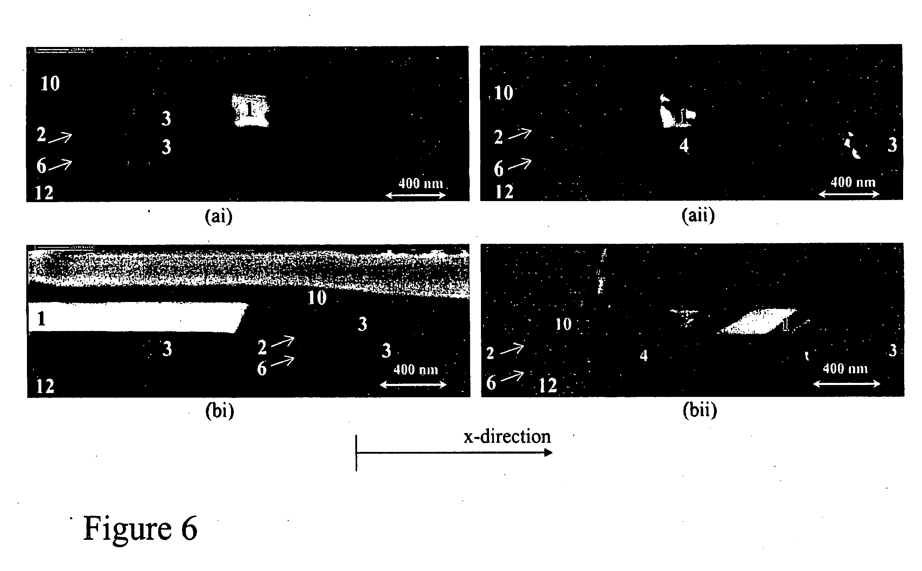

Figure 6 are cross-sectional FIB images of a standard Cu-SiO₂ single damascene stack after (i) 4 and (ii) 8 minutes of VHF etch. (a) represents a narrow line (low area), while (b) stands for a bondpad (large area). The x-direction is indicated on the figure.

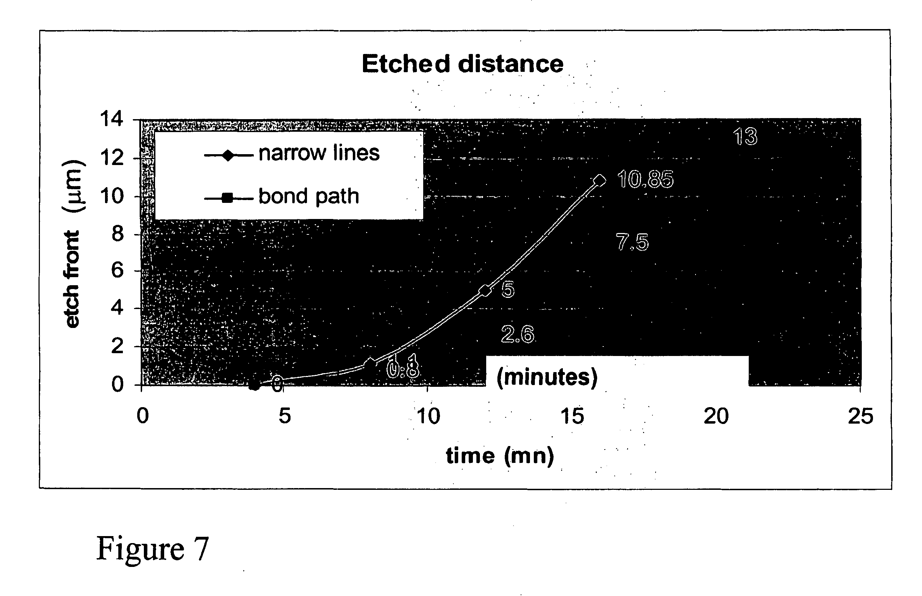

Figure 7 is a plot showing the etched distance (half of actual groove in x-direction) vs. time dependence of narrow lines and bond paths.

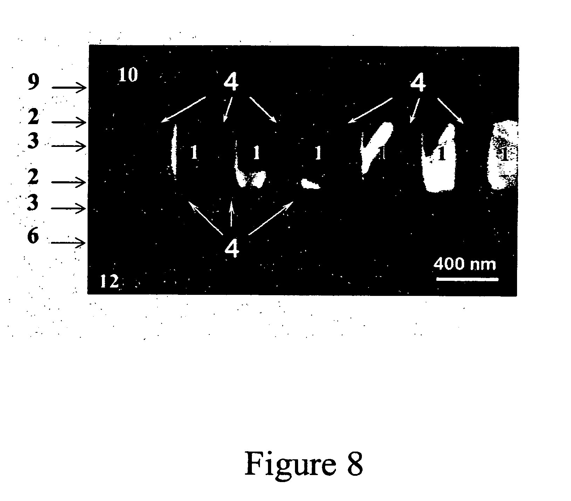

Figure 8 is a schematic representing the SD stack after an arbitrary VHF exposure time leading to the incorporation of an airgap underneath a Cu line. The preferential channels of HF diffusion are shown by black dots at the SiC / Ta(N) interface.

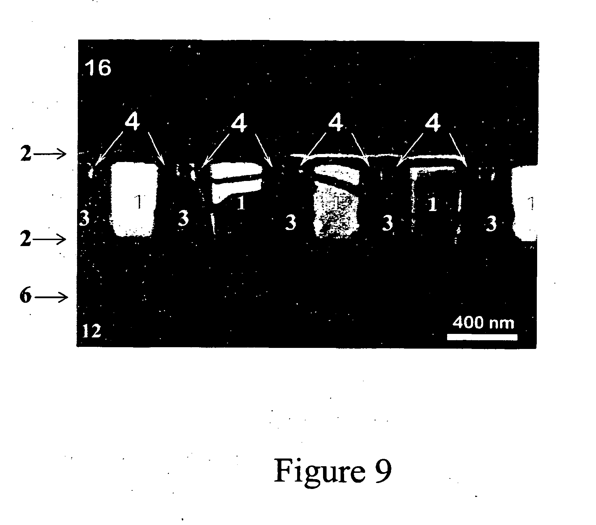

Figure 9 is a schematic representing the SD stack after an arbitrary VHF exposure time leading to the incorporation of airgaps between narrowly spaced (300 mm) lines. Here (16) refers to a SiC (50 nm) - SiO₂ (300 nm) - Si₃N₄ (500 nm) layer on top of the airgap structure.

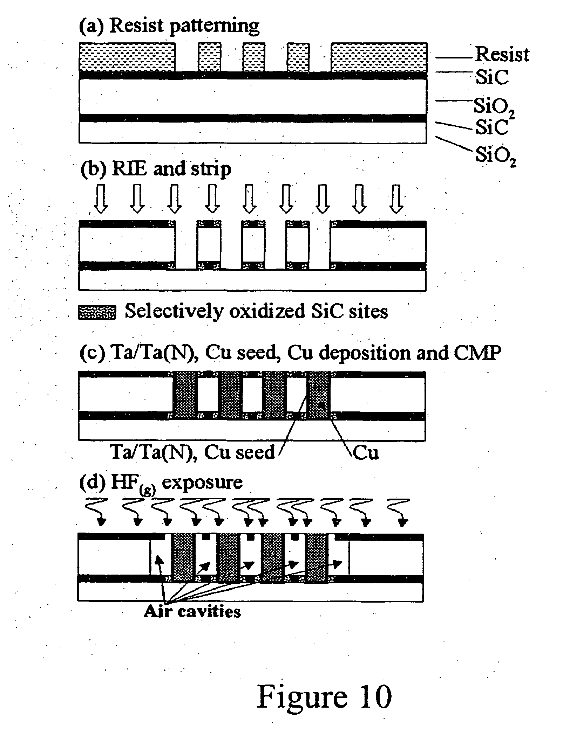

Figure 10 shows an additional process flow for airgap formation to illustrate the practical examples.

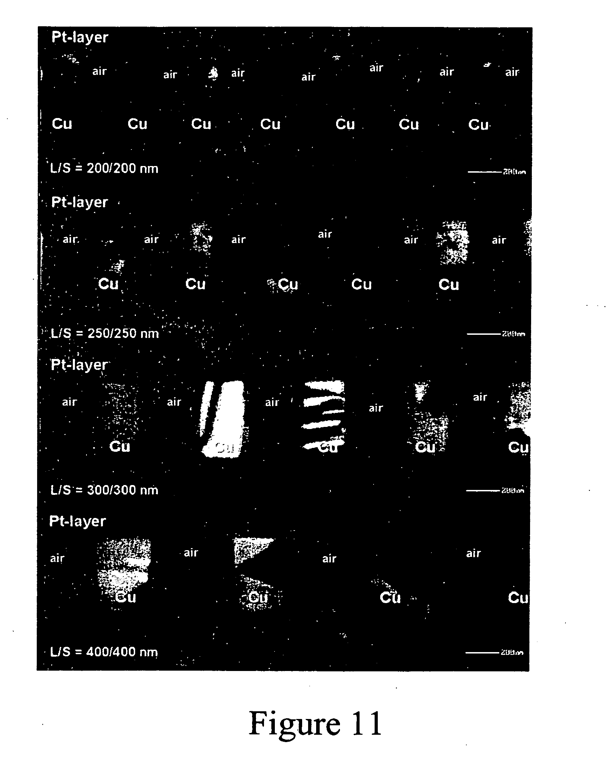

Figure 11 shows cross-sectional FIB images for structures with interline spacing of L/S = 200/200 nm, 250/250 nm, 300/300 nm and 400/400 nm. Air cavities are typically about half the height of the copper lines.

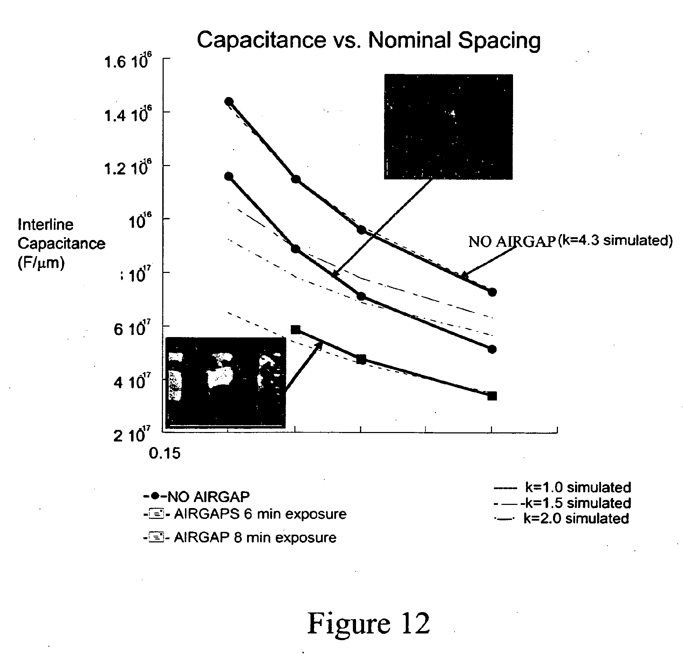

Figure 12 shows the interline capacitance versus nominal spacing after airgap formation with two different HF exposure times compared to samples without airgap formation.

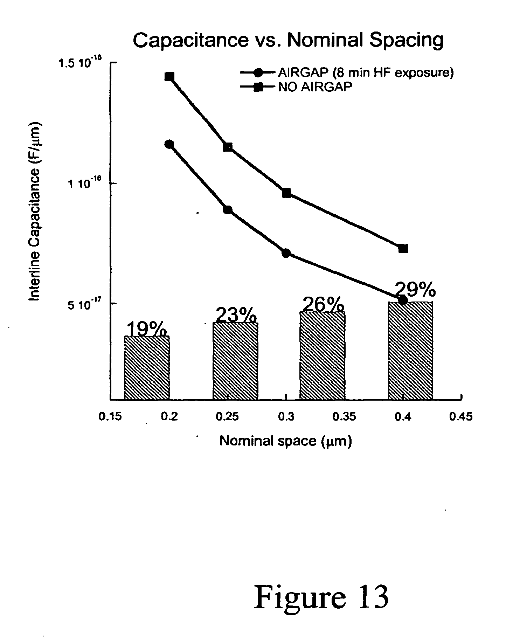

Figure 13 shows interline capacitance versus nominal spacing for samples with and without airgaps. Bars represent the capacitance drop due to airgaps. The drop in capacitance appears to be dependent on the spacing between two adjacent copper lines. This is because wider spaces allow accommodating bigger air cavities than smaller ones.

### Detailed description of the invention

The present invention provides a method for the production of airgaps in a semiconductor device as claimed in claim 1, the semiconductor device comprising a substrate layer and a stack of layers on top of the substrate layer, the stack of layers comprising at least one iteration of a sub-stack of layers, the sub-stack of layers comprising;
- a hardmask layer made of liner material;
- a layer made of dielectric or insulator material under the hardmask layer;
wherein
- the liner material is resistant to a first etching substance;
- the first etching substance is able to etch the dielectric insulator material;
the method comprising the steps of:
a) etching a hole in the stack of layers with a second etching substance, and simultaneously
b) chemically changing the properties of the liner material locally, whereby directly adjacent to said hole part of the liner material is converted locally, having in plane dimensions smaller than 1 µm, and becomes becomes etchable by the first etching substance,
c) creating in the hole a metal line made of a conductive material, optionally separated from the dielectric layer by a barrier layer, the metal line or, if present, the barrier layer being resistant to the first etching substance,
d) applying the first etching substance to the stack of layers thereby etching the converted material and the dielectric material so that airgaps are created around the metal line.

Preferably step (c) comprises the sub-steps of:
(i) optionally depositing a barrier layer,
(ii) depositing on top of the barrier layer a layer of electrically conductive material,
(iii) removing on top of the stack of layers the overburden of electrically conductive material and barrier layer
whereby at least 1 embedded line is created.

Said insulator material or dielectric material can also be referred to as first material.

The dielectric layer is situated under said hardmask layer.

The layer situated upon said dielectric layer has a function of (acts as) a hardmask layer.

Said layer situated upon said dielectric layer is thus referred to as a hardmask layer.

A layer of liner material in said stack of layers, situated under said dielectric layer, can act as etch stop layer, but this is not compulsory.

In preferred embodiments only the hardmask layer situated upon said dielectric layer is locally converted by said second etching substance and the etching of the hole is stopped on the layer of liner material situated under said dielectric layer. The layer of liner material situated under said dielectric layer is then acting as an etch stop layer.

In another preferred embodiment, both the layer acting as hardmask layer upon said dielectric layer and the layer of liner material dielectric under said dielectric layer (this layer is opened during the etching of the hole) are locally converted by said second etching substance.

The creation of the line in the hole can be performed by any standard technique.

Preferably step (c) comprises the sub-steps of:
(i) depositing a barrier layer,
(ii) depositing on top of the barrier layer a layer of electrically conductive material,
(iii) removing the overburden of conductive material and barrier layer by applying a subtractive technique on top of the stack of layers whereby at least 1 embedded line is created.

Examples of said subtractive technique are Chemical Mechanical polishing (CMP), Electro Polishing, etch or any combination of these mentioned techniques.

Examples of barrier layers are TaN, Ta, TiN, Ti, WN, WCN etc. These barrier layers can be deposited by Physical Vapour Deposition (PVD), Chemical Vapour Deposition (CVD), Metal Organic Chemical Vapour Deposition (MO-CVD), Atomic Layer Deposition (ALD) and related methods. This barrier layer can have a function of diffusion barrier to avoid diffusion of the conductive material in to the dielectric (e.g. low-k material).

In case the conducting material of the line is not resistant to the first etching substance and a barrier layer is present, an additional step of depositing a protective layer on the exposed part of the line before step (d) is performed can be preferred.

Preferably the conductive material is selected from the group of [metals, carbon nanotubes, conducting polymers]. The conductive material can be for example Cu, Au or Ag.

The filling of the holes leads to the creation of conductive lines. These conductive lines are preferably part of a (single or dual) damascene structure in a semiconductor device. This dual damascene structure is made of horizontal lines (also referred to as "trenches") and vertical structures (referred to as "vias"). Single and dual damascene structures are situated in the back end of line (BEOL) of semiconductor processing.

Airgaps of the present invention can be formed preferably near the trenches or preferably near the vias or preferably near vias and trenches. Most preferred the airgaps of the present invention are created near the vias.

The production of airgaps for electrical isolation purposes is an aim of the present invention, but airgaps can also be created in other contexts as for instance in the context of MEMS devices, where the airgap can be part of structurally or functionally.

The steps of etching a hole in the stack of layers, and chemically changing the properties of the liner material locally, are performed at the same time.

In other words, said step (a) of etching a hole and said step (b) of converting said liner material (2) into a material (7) that is etchable by said first etching composition, are simultaneous.

In preferred embodiment the hardmask layer material is silicon carbide (SiC).

In preferred embodiment the dielectric layer material is silicon dioxide (SiO₂).

Preferably, said dielectric layer material is deposited upon a Si₃N₄ layer (6), which can be referred to as an adhesion layer.

In preferred embodiments the liner material (e.g. SiC) is converted locally into the dielectric material (e.g. SiO₂).

The chemically changed part of the hardmask layer has preferably in-plane dimensions smaller than 500 nm, more preferably 100 nm. In-plane dimensions of smaller than 10 nm are easily possible.

The stack of layers can be typically a single or dual damascene stack, but is not limited thereto.

In specific embodiments the stack of layers further comprises a basis layer.

Preferably the basis layer (9) is resistant to the second etching substance, this way the etching of the hole in the stack of layers is downwards limited by the basis layer. The basis layer can thus also be an etch stop layer.

The basis layer can comprise metal.

An example of basis layer (9) resistant to said second etching composition (or substance) can be an organic low-k material. Other examples are silicon oxycarbide (SiCOH) materials rich in carbon molecules. The richer in carbon, the more resistant to said second etching substance is comparison with a silicon oxycarbide material used for said dielectric layer (3).

In certain embodiments according to the present invention, the basis layer is resistant to the first etching substance, which can be downwards limiting the formation of the airgaps.

In preferred embodiments, the second etching substance is an oxidizing substance.

In preferred embodiment the second etching substance comprises O₂.

In preferred embodiments, the second etching substance is a dry etch plasma comprising oxygen.

In a preferred embodiment the first etching substance comprises hydrofluoric acid (HF). The etching can be performed preferably in an HF vapour ambient but also an HF dip in a diluted HF solution is possible.

In case the first etching substance is an HF solution, an anhydrous HF solution instead of an aqueous HF solution (HF/H₂O mixture) is preferred because this is easier to control. Examples of the anhydrous HF solutions are HF/alcolhol (e.g. methanol) mixtures.

In a preferred embodiment the hole is formed at the back end of line (BEOL) processing.

In a preferred embodiment the basis layer comprises an embedded metal line.

In a preferred embodiment the embedded metal line and the metal line are forming an electrical contact.
In preferred embodiments the method according to the present invention can be repeated. It is shown that on top of an airgap structure new layers can be formed, on which the method according to the present invention can be repeated.

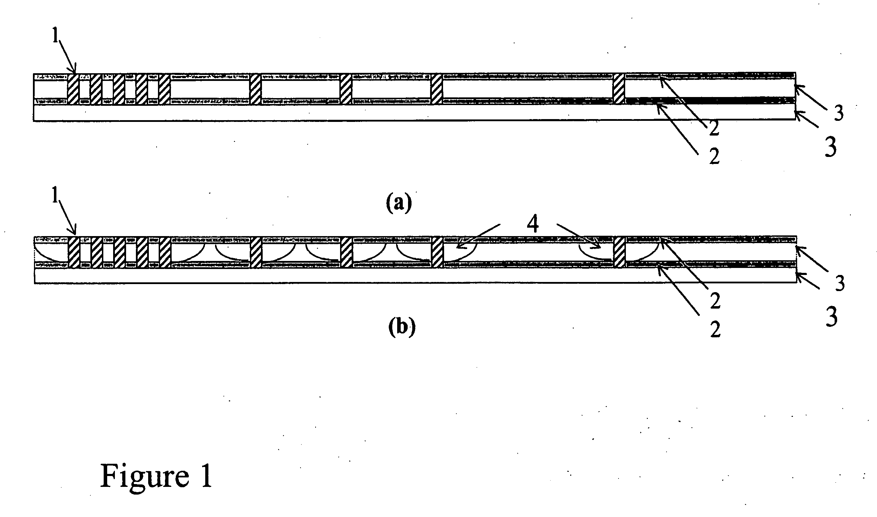

Figure 1 represents a standard Cu single damascene (SD) stack before (a) and after (b) etch of material between narrowly spaced interconnects (1). Typical interconnects are metals (ie. Cu, Au, Ag...) embedded in a (3) dielectric stack which also contains liners (2). The dielectric material and liner are deposited on a Si or other substrate (which is not shown in the Figures) by a method such as Plasma Enhanced Chemical Vapour Deposition (PECVD), Chemical Vapour Deposition (CVD), spin-on deposition etc.

Layer (3) is typically SiO₂ (k= 4.2) or another Si containing insulator material with lower k value such as SiOC:H materials (Carbon doped oxides, commonly referred to as silicon oxy carbides).

When said layer (3) is made of SiOC:H material, the carbon content should be low (enough) so that the etching step by said first etching composition is not hampered.

An example for the liner material of layer (2) is any carbon containing Si compound such as SiC, SiC:H etc. In Fig. 1 items (4) represent selectively incorporated airgaps.

The layer (2) situated upon layer (3) has the function of a hardmask layer.

In preferred embodiments according to the present invention metal lines (1), for instance Cu lines, are embedded in a dielectric material (3) (i.e. SiO₂). The metal lines (1) are typically further separated from the dielectric material (3) by a barrier layer (not shown in the figures), as for instance a Ta/Ta(N) barrier. This barrier layer can have a function as diffusion barrier. A hard mask (2) is deposited on top (for instance SiC), which is resistant to etching agents for the dielectric layer material (for instance HF) and is preferrably non-conducting. An induced local conversion of the liner, before the creation of the metal line (1), has to be performed (possible at nanometer scale), generating vulnerable spots (plugs). For instance a localised plasma conversion of the SiC liner into SiO₂. The plugs are expected to act as preferential channels for chemical diffusion. A metal line and typically also a barrier layer is deposited. A dissolution of the dielectric material follows by applying the etching agent. This takes place preferentially between narrowly spaced Cu lines.

The overburden of said deposited metal (conductive material) and the overburden of said barrier material are removed and planarized with standard removal techniques such as Chemical Mechanical Polishing (CMP).

A way to selectively introduce air between narrowly spaced Cu interconnects in a single step is disclosed being fully compatible with the back end of line process as illustrated in Figure 1.

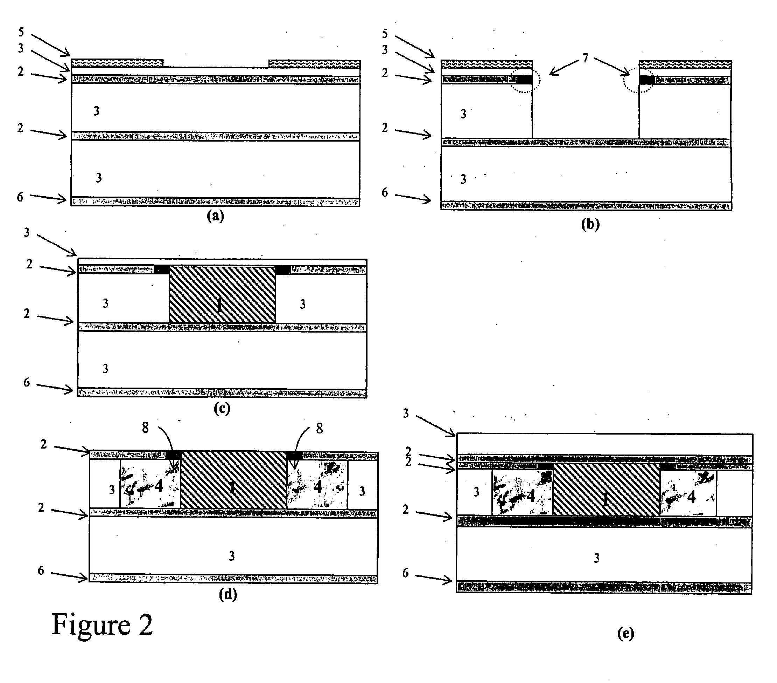

A preferred embodiment of the present invention (Figure 2) is as follows: the starting point of the process is a standard Cu single or dual damascene stack as described in Figure 2a. The dry etch step takes place in an O₂ containing plasma and leads to local oxidation of the liner (i.e. SiC) (Figure 2b).

The dry etch sequence, for formation of vias and trenches, starts with an oxygen/fluorcarbon plasma with a high amount of oxygen to open the hardmask and subsequently a less oxygen rich plasma is applied (higher amount of fluorocarbon) to create an opening in the Si containing insulator (e.g. SiO₂ ).

The dry etch process is anisotropic which means that the lateral etching is negligible compared to the vertical etching.

The anisotropic etch process is performed until the liner layer (2) situated under the Si containing insulator layer (3) (also referred to as dielectric layer) is reached.

The liner material layer (2) situated under the dielectric layer (3) is acting here as an etch stop layer.

Both liner material layers (hardmask and etch stop layer) are preferably SiC.

During the dry etching process, a part of the hardmask layer (e.g. SiC), situated at the sidewall of the opening, is due to the oxygen rich plasma oxidised to SiO₂.

The dimensions of the converted part of the SiC hardmask is in the nanometer range, preferably 100 nm or smaller.

The liner material layer (2) acting as etch stop layer is preferably not converted by the oxygen rich plasma.

Figure 2c shows the stack after barrier layer deposition (Ta/TaN (10/15 nm)), Cu seed layer deposition (100 nm), Cu electroplating (1 µm) and chemical mechanical polishing (CMP). Typical examples for barrier are TaN, Ta, TiN, Ti, WN, WCN etc. Currently employed methods for depositing a barrier are Plasma Enhanced Chemical Vapour Deposition (PECVD), Chemical Vapour Deposition (CVD), spin-on deposition etc. Figure 2 (d) is after dielectric etching employing for instance vapour HF (VHF) (or any other compound etching the dielectric) (8) generating air cavities (4) near the dielectric / barrier interface. The range of SiC/SiO₂ conversion is in the nanometer range which is sufficient to allow diffusion of HF molecules to the underlying SiO₂ layers. The fact that this is a Ta(N)/SiC interface dependent process results in accelerated dissolution of SiO₂ laying between narrowly spaced Cu lines, compared to bare SiO₂ (existing between largely spaced Cu lines). The resulting stack is mechanically and chemically stable to allow further processing as depicted in Figure 2e. In the latter figure a thick conformal layer, such as liner or dielectric (2)/(3), has been deposited on top of the air cavities.

Another preferred embodiment of the present invention (FIGURE 3) is as follows:

As in the first embodiment, the starting point is a standard Cu single or dual damascene stack as described in Figure 3a, with a difference being the presence of a HF resistant layer (9) (i.e. Chemically deposited SiOC) as a basis layer under the Cu lines. The dry etch step takes place in an O₂ containing plasma, leading to local oxidation (7) of the liner material (i.e. SiC) (Figure 3b). The resulting stack is mechanically and chemically stable to allow further processing as depicted in Figure 3e. Note that no airgap is generated underneath the Cu lines allowing a better mechanical stability of the stack.

The basis layer is preferably resistant to the second etching substance, this way the etching of the hole is downwards limited by the basis layer. This basis layer can comprise a metal structure.

Another preferred embodiment of the present invention (FIGURE 4) is as follows: The starting point is a standard Cu single or dual damascene stack as described in Figure 4a. The dry etch step takes place in an O₂ plasma (see Figure 4b) generating plugs at the SiC/Ta(N) interface (Figure 4b). After resist strip, a supplementary conformal CVD SiC liner (i.e. 50 nm) is deposited, covering the whole exposed surface (Figure 4c). An isotropic O₂ plasma treatment is then applied in order to open the bottom SiC as shown in Figure 4d. VHF will diffuse through the induced plugs to the adjacent SiO₂ material, while leaving the Cu lines embodied with SiC (Figure 4e). The resulting stack is mechanically and chemically stable to withstand further processing (Figure 4f).

Preferably no airgaps are formed in the basis layer (9). The basis layer (9) is preferably resistant to the second etching etching substance, this way the etching of the hole is downwards limited by the basis layer (9). This basis layer can comprise a metal structure (as shown in Figure 4ii).

When one considers the size of created airgaps (4) as a measure, the duration of the step of "chemically changing the properties of the liner layers locally" is less critical, as compared to duration of the step "applying the etching substance to the stack of layers". Independent of the size of the area of the liner layers which is chemically changed, the airgap size can be controlled by a controlled duration of the step of "applying the etching substance to the stack of layers".

The distance between neighbouring conductor lines is determined by the limitations of state-of-the-art techniques with respect to forming neighbouring holes in the stack of layers. Typically metal lines are spaced at about 1 µm. The present invention is scaling invariant and is not limited to any distance between conductor lines, since the step of "chemically changing the properties of the liner layers locally" can be applied on nanometer scale and smaller.

### Practical examples

### Example 1: Practical example and process parameters

A 200 mm wafer consisted of a standard single-damascene (SD) stack including a 600 nm SiO₂ on a 50 nm SiC liner lying on top of a 500 nm SiO₂ supported on a 50 nm Si₃N₄ adhesion layer on a Si(100) as shown in Figure 2a. After lithography, the stack was dry etched until opening of the SiC layer as shown in Figure 2b. Subsequently a 25 nm Ta(N) diffusion barrier (10 nm Ta(N), 15 nm Ta) and a 100 nm Cu seed layer were deposited by self ionised plasma (SIP). The trenches were filled by Cu electroplating (Figure 2c) and the remaining material removed by chemical mechanical polishing (see Figure 2d).

Organosilicon trimethylsilane gas and He at a pressure of ca. 8 Torr were employed as precursors for a-SiC:H (amorphous hydrogenated SiC). For SiO₂, SiH4 and N₂O at 2.6 Torr served as precursors. The main mechanical characteristic of a-SiC:H (also referred to as BLOK or barrier low-k) is a +40 to +300 MPa stress

The dry etch consisted according to the following conditions:- Pressure range: 175 and 70 mTorr (double step SiO₂ etch) and 90 mTorr (SiC etch) (1 Torr = 133 Pa).

- Temperature: chuck temperature is set at 20 degrees C; wafer temperature during dry etch sequence can ramp up to 70-80 degrees C depending on the process specifications and duration

- Species:

*SiO₂ is etched in a 2-step sequence, including a main etch based on Ar, O₂, CF₄ and CHF₃ (low SiO₂/SiC selectivity) plus an additional overetch based on Ar, C₄F₈, O₂.

*SiC is etched with a plasma composed on Ar, N₂, CF₄, CHF₃.

- Etch time: depends on the features size and depth, but typically takes ~ 60s for etching a 250nm wide trench over a depth of 600nm (SiO₂ main etch step).

The strip was done in two steps (i) dry strip which employed vapour H₂O and (ii) wet strip.

Additionally, the samples underwent a well controlled SiO₂ etch by using a HF solution (49 % clean room compatible). The amount of etched SiO₂ can be easily controlled by the time and temperature employed. Fig. 7 is a plot of etch rate vs. VHF exposure and Fig. 8 shows the resulting incorporated airgaps. Fig. 8 is a schematic of a typical cross-sectioned SD stack after VHF exposure.

### Example 2: Process flow for airgap formation

The overall process is shown in Figure 10. In first place, the stack composed of a 50/500/50/600/50 nm Si₃N₄/SiO₂/SiC/SiO₂/SiC was formed on a Si (100) wafer by plasma enhanced chemical vapor deposition (PE-CVD). Patterning was achieved by 248 nm wavelength optical lithography (Figure 10a). Reactive ion etch (RIE) was carried out in an Ar/N₂/O₂/CF₄/C₄F₈ mixture at 70 mTorr. Resist strip was carefully controlled to induce local SiC oxidation at the sidewalls by using a H₂O(v)/CF₄ gas mixture at 1100 mTorr (Figure 10b). Then a 15/10 nm Ta/Ta(N) diffusion layer and a 100 nm Cu seed layer were formed by ionized physical vapor deposition (i-PVD). Trenches were filled by copper electroplating and the exceeding metal was removed by chemical mechanical polishing (CMP) as shown in Figure 10c. At this point the wafer was cut into 2 x 2 cm² dies. Single dies were exposed to an HF/Methanol gas phase mixture (HF(g)) by means of a MEMS-CET system (Primaxx, PA, USA) at low pressure. HF(g) readily dissolves the locally oxidized SiC and diffuses through the Ta(N)/SiC interface leading to the dissolution of the underlying SiO₂, and formation of full airgaps as depicted in Figure 10d. The amount of etched SiO₂ was mainly controlled by tuning the HF(g) exposure time. Gas temperature and pressure were also employed to finely tune the etch rate.

Figure 11 shows cross-sectional FIB images of meander-fork structures. The airgaps appear to be formed as a result of an isotropic dissolution of the SiO₂ dielectric material as no preferred etching direction is observed. Under the experimental conditions employed, SiO₂ etch seems to be very selective avoiding any attack of the Ta/Ta(N) barrier. In addition, the top SiC layer remains in place even after a Pt layer is FIB deposited on top before imaging.

### Example 3: Electrical characterization

Capacitance was measured between 1-2 cm long meanders and forks with nominal line width/spacing (L/S) comprised between 200/200 and 400/400 nm, using an HP4284A LCR meter at 100 kHz assuming a parallel RC model for the impedance. All experimental data are reported on Table 2.

**Table 2. Capacitance (pF) data vs. etch time for samples after etching with HF.**

| **L/S** (micron) | **HF etch time (minutes)** | | | | | | | | |
|---|---|---|---|---|---|---|---|---|---|
| | **3** | **4** | **5** | **6** | **6** | **5** | **6** | **7** | **8** |
| | 1-3 | 1-4 | 1-5 | 1-6 | 1--6-2 | 2-5 | 2-6 | 2-7 | 2-8 |
| **0.2/0.2** | 6.8 | 6.52 | // | 6 | // | 6.58 | 6.63 | 5.83 | 5.34 |
| | 6.74 | 6.5 | // | 6.06 | 3.06 | 6.32 | 6.67 | 5.81 | 5.34 |
| | 6.76 | 6.52 | // | 6.05 | 6.01 | // | 6.68 | 5.82 | 5.35 |
| | 6.75 | 6.62 | 5.88 | 6.07 | 6.05 | 6.84 | 6.76 | 5.81 | 5.38 |
| | 6.78 | // | // | 6 | // | 6.82 | 6.69 | 5.79 | 5.36 |
| | // | 6.59 | 5.82 | 5.86 | 5.86 | 6.97 | 6.69 | 5.79 | 5.35 |
| ***average*** | ***6.766*** | ***6.55*** | ***5.85*** | ***6. 01*** | ***5.97*** | ***6.71*** | ***6.69*** | ***5.81*** | ***5.35*** |
| **0.25/0.25** | 4.06 | 3.98 | 3.34 | 3.51 | // | 3.99 | 4.07 | 3.67 | 3.28 |
| | 4.02 | 3.96 | // | 3.5 | // | 3.95 | 4.07 | 3.66 | 3.27 |
| | 4.01 | 3.97 | // | 3.48 | 3.5 | 3.91 | 4.06 | 3.69 | 3.27 |
| | 4.08 | 4.03 | // | 3.54 | // | 3.94 | 4.09 | 3.73 | 3.26 |
| | 4.04 | 4.02 | // | 3.53 | // | 3.95 | 4.07 | 3.68 | 3.26 |
| | 4.03 | 4.01 | // | 3.53 | // | 3.96 | 4.06 | 3.7 | 3.27 |
| ***average*** | ***4.04*** | ***4.00*** | ***3.34*** | ***3.52*** | ***3.50*** | ***3.95*** | ***4.07*** | ***3.69*** | ***3.27*** |
| **0.3/0.3** | 2.68 | 2.69 | // | 2.36 | 2.36 | 2.63 | 2.74 | 2.53 | 2.18 |
| | 2.67 | 2.68 | // | 2.35 | // | 2.73 | 2.73 | 2.53 | 2.18 |
| | 2.66 | 2.68 | // | 2.35 | 2.34 | 2.73 | 2.72 | 2.53 | 2.18 |
| | 2.69 | 2.74 | // | 2.4 | 2.39 | 2.66 | 2.75 | 2.59 | 2.2 |
| | 2.7 | 2.73 | // | 2.4 | 2.38 | 2.68 | 2.76 | 2.6 | 2.21 |
| | 2.7 | 2.73 | // | 2.41 | 2.38 | 2.97 | 2.77 | 2.58 | 2.21 |
| ***average*** | ***2.68*** | ***2.71*** | // | ***2.38*** | ***2.37*** | ***2.73*** | ***2.75*** | ***2.56*** | ***2.19*** |
| **0.4/0.4** | 1.49 | 1.5 | 1.21 | 1.29 | // | 1.48 | 1.53 | 1.42 | 1.19 |
| | 1.49 | 1.49 | 1.21 | 1.28 | // | 1.46 | 1.53 | 1.42 | 1.19 |
| | 1.49 | 1.49 | 1.21 | 1.28 | // | 1.45 | 1.53 | 1.42 | 1.19 |
| | 1.54 | 1.51 | 1.23 | 1.31 | // | 1.49 | 1.57 | 1.47 | 1.18 |
| | 1.51 | 1.5 | 1.22 | 1.3 | // | 1.47 | 1.54 | 1.46 | 1.18 |
| | 1.5 | 1.5 | 1.21 | 1.3 | // | 1.47 | 1.54 | 1.45 | 1.18 |
| ***average*** | ***1.50*** | ***1.51*** | ***1.22*** | ***1.29*** | // | ***1.47*** | ***1.54*** | ***1.44*** | ***1.19*** |

| | | | | | | | | | |
|---|---|---|---|---|---|---|---|---|---|
| //: no data available | | | | | | | | | |

### Example 4: Full size and half size airgaps between copper lines

Figure 12 shows the capacitance performance for two sets of experiments leading to dies with full size (first set of experiment) and half size airgaps (second set of experiments). Half size airgaps correspond to air cavities equal to half the height of the copper line. As shown in Figure 12 samples with lower capacitance showed full airgaps, however samples with half size airgaps seemed to be much more stable than samples with full airgaps between the copper lines. The etch time or HF exposure time was not the only important factor to determine the size of the airgaps, also temperature and pressure of the chamber (different for the two sets of experiments) was important in determining the size of the airgaps.

### Example 5: TEM and EFTEM observations.

A typical cross-sectional TEM image of the SD stack is shown in Fig.5 at low (a) and high (b) resolution. The right side of the sample in Fig. 5a corresponds to the thinnest part of the wedge as evidenced by its lighter contrast. The spherical profile of the SiC layer in the vicinity of the SiC / Ta(N) interface visible by TEM and supported by EFTEM suggest that this layer has been locally converted to SiO₂ importantly decreasing its contact area with the Ta(N) barrier wall. This SiC / SiO₂ conversion is ascribed to the action of the oxygen containing plasma employed at the dry etch step.

### Example 6: FIB, SEM and optical microscopy observations.

Figure 6a shows typical FIB cross-sectional images of and isolated Cu line as the surrounding SiO₂ is gradually dissolved after VHF exposure. Half of the upper SiO₂ layer is removed after 4 mn of etch as shown in Fig.6ai. As the HF exposure continues, the underlying SiO₂ film is progressively removed underneath the SiC / Ta(N) interface (leading to the incorporation of air under the metal structure). The afore-mentioned phenomenon proved to take place selectively for SiO₂ material lying beneath any SiC / Ta(N) interface. After prolonged HF etch times (more than ca. 8 mn) the stack modification can be easily monitored by optical inspection.

Figure 9 is a schematic representing the SD stack after an arbitrary VHF exposure time leading to the incorporation of airgaps between narrowly spaced (300 mm) lines. This figure shows that deposition of new layers on top of the airgap structure is possible. Here (16) refers to a SiC (50 nm) - SiO₂ (300 nm) -Si₃N₄ (500 nm) layer. This shows moreover that dielectric layers, hardmask layers and if appropriate, basis layers can be formed on top of the airgap structure, after which the embodiments of the present invention can be repeated.

## Claims

1. Method for making airgaps (4) in a stack of layers of a semiconductor device, said stack of layers comprising:
- a first layer of a first material (2), said first layer being a hardmask layer of a liner material resistant to a first etching substance or composition,
- a second layer of a second material (3) being a dielectric or an insulator material, said second layer being etchable by said first etching substance or composition,
said second layer of a second material (3) being situated under said first layer of a first material (2), and
- a patterned resist layer (5) atop;
said method comprising the steps of:
a) etching with a second etching substance or composition at least one hole in said first layer of a first material (2) and said second layer of a second material (3), and simultaneously chemically converting a part of said first layer of a first material (2) locally, directly adjacent to said hole, into a converted material (7), having in plane dimensions smaller than 1µm, wherein said converted material (7) is etchable by said first etching substance or composition,
b) creating in said hole a line (1) made of a conductive material, said line (1) being resistant to said first etching substance or composition,
c) contacting said first etching substance or composition with said stack of layers for etching said converted material (7) and said second material (3) of said second layer, thereby creating airgaps (4) around said line (1).

2. A method according to claim 1, wherein said layer of a second material (3) is situated between two layers of a first material (2).

3. A method according to claim 2, wherein the lower one of the layers of a first material (2) is an etch stop layer.

4. A method according to any of the preceding claims, wherein step (b) comprises the steps of:
- depositing a barrier layer,
- depositing on top of said barrier layer a layer of an electrically conductive material,
- removing on top of said stack of layers the overburden of said electrically conductive material and of said barrier layer.

5. A method according to any of the preceding claims, wherein a protective layer is deposited on the exposed part of said line (1) before said step (c) of contacting said first etching substance or composition with said stack of layers is performed.

6. A method according to any of the preceding claims, wherein said conductive material is selected from the group consisting of metals, carbon nanotubes, and conducting polymers.

7. A method according to claim 6, wherein said conductive material is Cu, Au or Ag.

8. A method according to any of the preceding claims, wherein said stack of layers further comprises a basis layer (9).

9. A method according to claim 8, wherein said basis layer (9) is resistant to said first etching substance or composition.

10. A method according to claim 8 or 9, wherein said basis layer (9) is resistant to said second etching substance or composition.

11. A method according to any of claims 8 to 10, wherein said basis layer (9) comprises an embedded metal line.

12. A method according to any of the preceding claims, wherein the chemically converted part (7) of said first material (2) has in-plane dimensions smaller than 500 nm, preferably smaller than 100 nm, and more preferably smaller than 10 nm.

13. A method according to any of the preceding claims, wherein said second material (3) is silicon dioxide (SiO₂).

14. A method according to any of the preceding claims, wherein said first layer material (2) is silicon carbide (SiC).

15. A method according to any of the preceding claims, wherein said second etching substance or composition is a dry etch plasma comprising O₂.

16. A method according to claim 15, wherein said O₂ comprising plasma further comprises at least one (hydro)fluorocarbon compound.

17. A method according to claim 16, wherein said (hydro)fluorocarbon compound is selected from the group consisting of CF₄, CHF₃, and C₄F₈.

18. A method according to any of the preceding claims, wherein said first etching substance or composition comprises hydrofluoric acid (HF).

19. A method according to any of the preceding claims, wherein said first etching substance or composition consists of a solution of 49 wt.% HF.

20. A method according to claim 18, wherein said HF is an HF vapour.

21. A method according to any of the preceding claims, wherein said stack of layers is a single or dual damascene stack.

22. A method according to any of the preceding claims, wherein said method is carried cut at the back end of line (BEOL) processing

23. A method according to claim 11 or any claim dependent on claim 11, wherein said embedded line in basis layer (9) and said line (1) are forming an electrical contact.

24. A method for fabricating a semiconductor device having airgaps comprising a method according to any of the preceding claims.

25. A method for fabricating a semiconductor device having airgaps according to claim 24 wherein the following steps are repeated at least twice:
- carrying out a method according to any of the preceding claims, and
- creating a next stack of layers on top of the airgap structure resulting from the preceding step.

## Patentansprüche

1. Verfahren zum Herstellen von Luftspalten (4) in einem Stapel aus Schichten einer Halbleitervorrichtung, wobei der Stapel aus Schichten umfasst:
- eine erste Schicht aus einem ersten Material (2), wobei die erste Schicht eine Hartmaskenschicht aus einem Mantelmaterial ist, das gegenüber einer ersten Ätzsubstanz oder -zusammensetzung beständig ist,
- eine zweite Schicht aus einem zweiten Material (3), das ein dielektrisches oder ein Isoliermaterial ist, wobei die zweite Schicht von der ersten Ätzsubstanz oder -zusammensetzung ätzbar ist,
wobei die zweite Schicht aus einem zweiten Material (3) unter der ersten Schicht aus einem ersten Material (2) angeordnet ist, und
- eine strukturierte aufliegende Resistschicht (5); wobei das Verfahren die folgenden Schritte umfasst:
a) Ätzen zumindest eines Lochs in die erste Schicht aus einem ersten Material (2) und die zweite Schicht aus einem zweiten Material (3) mit einer zweiten Ätzsubstanz oder -zusammensetzung, und gleichzeitiges chemisches Umwandeln eines Teils der ersten Schicht aus einem ersten Material (2), lokal direkt benachbart dem Loch, in ein umgewandeltes Material (7) mit Abmessungen in der Ebene von weniger als 1 µm, wobei das umgewandelte Material (7) von der ersten Ätzsubstanz oder -zusammensetzung ätzbar ist,
b) Bilden einer Leitung (1) in dem Loch, die aus einem leitfähigen Material hergestellt ist, wobei die Leitung (1) gegenüber der ersten Ätzsubstanz oder -zusammensetzung beständig ist,
c) Inkontaktbringen der ersten Ätzsubstanz oder - zusammensetzung mit dem Stapel aus Schichten zum Ätzen des umgewandelten Materials (7) und des zweiten Materials (3) der zweiten Schicht, um dadurch Luftspalten (4) um die Leitung (1) herum zu bilden.

2. Verfahren nach Anspruch 1, wobei die Schicht aus einem zweiten Material (3) zwischen zwei Schichten aus einem ersten Material (2) angeordnet ist.

3. Verfahren nach Anspruch 2, wobei die untere der Schichten aus einem ersten Material (2) eine Ätzstoppschicht ist.

4. Verfahren nach einem der vorstehenden Ansprüche, wobei Schritt (b) die folgenden Schritte umfasst:
- Auftragen einer Barriereschicht,
- Auftragen einer Schicht aus einem elektrisch leitfähigen Material obenauf auf die Barriereschicht,
- Entfernen der Überdeckung des elektrisch leitfähigen Materials und der Barriereschicht von ganz oben am Stapel aus Schichten.

5. Verfahren nach einem der vorstehenden Ansprüche, wobei eine Schutzschicht auf den exponierten Teil der Leitung (1) aufgetragen wird bevor Schritt (c) des Inkontaktbringens der ersten Ätzsubstanz oder -zusammensetzung mit dem Stapel aus Schichten durchgeführt wird.

6. Verfahren nach einem der vorstehenden Ansprüche, wobei das leitfähige Material aus der Gruppe bestehend aus Metallen, Kohlenstoffnanoröhrchen, und Leitpolymeren ausgewählt ist.

7. Verfahren nach Anspruch 6, wobei das leitfähige Material Cu, Au oder Ag ist.

8. Verfahren nach einem der vorstehenden Ansprüche, wobei der Stapel aus Schichten ferner eine Basisschicht (9) umfasst.

9. Verfahren nach Anspruch 8, wobei die Basisschicht (9) gegenüber der ersten Ätzsubstanz oder -zusammensetzung beständig ist.

10. Verfahren nach Anspruch 8 oder 9, wobei die Basisschicht (9) gegenüber der zweiten Ätzsubstanz oder - zusammensetzung beständig ist.

11. Verfahren nach einem der Ansprüche 8 bis 10, wobei die Basisschicht (9) eine eingebettete Metallleitung umfasst.

12. Verfahren nach einem der vorstehenden Ansprüche, wobei der chemisch umgewandelte Teil (7) des ersten Materials (2) Abmessungen in der Ebene von weniger als 500 nm, vorzugsweise weniger als 100 nm, und mehr bevorzugt weniger als 10 nm aufweist.

13. Verfahren nach einem der vorstehenden Ansprüche, wobei das zweite Material (3) Siliciumdioxid (SiO₂) ist.

14. Verfahren nach einem der vorstehenden Ansprüche, wobei das erste Schichtmaterial (2) Siliciumcarbid (SiC) ist.

15. Verfahren nach einem der vorstehenden Ansprüche, wobei die zweite Ätzsubstanz oder -zusammensetzung Trockenätzplasma ist, das O₂ umfasst.

16. Verfahren nach Anspruch 15, wobei das O₂-umfassende Plasma ferner zumindest eine Fluorkohlenwasserstoffverbindung umfasst.

17. Verfahren nach Anspruch 16, wobei die Fluorkohlenwasserstoffverbindung aus der Gruppe bestehend aus CF₄, CHF₃, und C₄F₈ ausgewählt ist.

18. Verfahren nach einem der vorstehenden Ansprüche, wobei die erste Ätzsubstanz oder -zusammensetzung Fluorwasserstoffsäure (HF) umfasst.

19. Verfahren nach einem der vorstehenden Ansprüche, wobei die erste Ätzsubstanz oder -zusammensetzung aus einer Lösung aus 49 Gew.-% HF besteht.

20. Verfahren nach Anspruch 18, wobei die HF ein HF-Dampf ist.

21. Verfahren nach einem der vorstehenden Ansprüche, wobei der Stapel aus Schichten ein Einzel- oder Doppeldamaszener-Stapel ist.

22. Verfahren nach einem der vorstehenden Ansprüche, wobei das Verfahren bei der BEOL-(Back end of line-)-Verarbeitung durchgeführt wird.

23. Verfahren nach Anspruch 11 oder einem von Anspruch 11 abhängigen Anspruch, wobei die eingebettete Leitung in der Basisschicht (9) und die Leitung (1) einen elektrischen Kontakt bilden.

24. Verfahren zum Herstellen einer Halbleitervorrichtung mit Luftspalten, das ein Verfahren nach einem der vorstehenden Ansprüche umfasst.

25. Verfahren zum Herstellen einer Halbleitervorrichtung mit Luftspalten nach Anspruch 24, wobei die folgenden Schritte zumindest zweimal wiederholt werden:
- Durchführen eines Verfahrens nach einem der vorstehenden Ansprüche, und
- Bilden eines nächsten Stapels aus Schichten obenauf auf der Luftspaltenstruktur, die im vorherigen Schritt gebildet wurde.

## Revendications

1. Procédé pour réaliser des entrefers (4) dans une pile de couches d'un dispositif à semi-conducteur, ladite pile de couches comprenant :
- une première couche d'un premier matériau (2), ladite première couche étant une couche de masque dur d'un matériau de séparation résistant à une première substance ou composition de gravure,
- une deuxième couche d'un deuxième matériau (3) étant un matériau diélectrique ou isolant, ladite deuxième couche pouvant être gravée par ladite première substance ou composition de gravure,
ladite deuxième couche d'un deuxième matériau (3) étant située sous ladite première couche d'un premier matériau (2), et
- une couche de réserve structurée (5) par-dessus ; ledit procédé comprenant les étapes :
a) de gravure, avec une deuxième substance ou composition de gravure, d'au moins un trou dans ladite première couche d'un premier matériau (2) et ladite deuxième couche d'un deuxième matériau (3), et simultanément de conversion chimique d'une partie de ladite première couche d'un premier matériau (2) localement, directement adjacente au dit trou, en un matériau converti (7), ayant des dimensions dans le plan inférieures à 1 µm, dans lequel ledit matériau converti (7) peut être gravé par ladite première substance ou composition de gravure,
b) de création, dans ledit trou, d'une ligne (1) constituée d'un matériau conducteur, ladite ligne (1) étant résistante à ladite première substance ou composition de gravure,
c) de mise en contact de ladite première substance ou composition de gravure avec ladite pile de couches pour graver ledit matériau converti (7) et ledit deuxième matériau (3) de ladite deuxième couche, créant de ce fait des entrefers (4) autour de ladite ligne (1).

2. Procédé selon la revendication 1, dans lequel ladite couche d'un deuxième matériau (3) est située entre deux couches d'un premier matériau (2).

3. Procédé selon la revendication 2, dans lequel la couche inférieure parmi les couches d'un premier matériau (2) est une couche d'arrêt de gravure.

4. Procédé selon l'une quelconque des revendications précédentes, dans lequel l'étape (b) comprend les étapes :
- de dépôt d'une couche de barrière,
- de dépôt, sur ladite couche de barrière, d'une couche d'un matériau électriquement conducteur,
- d'enlèvement, du dessus de ladite pile de couches, de la couche supérieure dudit matériau électriquement conducteur et de ladite couche de barrière.

5. Procédé selon l'une quelconque des revendications précédentes, dans lequel une couche de protection est déposée sur la partie exposée de ladite ligne (1) avant que ladite étape (c) de mise en contact de ladite première substance ou composition de gravure avec ladite pile de couches soit exécutée.

6. Procédé selon l'une quelconque des revendications précédentes, dans lequel ledit matériau conducteur est sélectionné dans le groupe consistant en des métaux, des nanotubes de carbone et des polymères conducteurs.

7. Procédé selon la revendication 6, dans lequel ledit matériau conducteur est Cu, Au ou Ag.

8. Procédé selon l'une quelconque des revendications précédentes, dans lequel ladite pile de couches comprend en outre une couche de base (9).

9. Procédé selon la revendication 8, dans lequel ladite couche de base (9) est résistante à ladite première substance ou composition de gravure.

10. Procédé selon la revendication 8 ou 9, dans lequel ladite couche de base (9) est résistante à ladite deuxième substance ou composition de gravure.

11. Procédé selon l'une quelconque des revendications 8 à 10, dans lequel ladite couche de base (9) comprend une ligne métallique intégrée.

12. Procédé selon l'une quelconque des revendications précédentes, dans lequel la partie convertie chimiquement (7) dudit premier matériau (2) a des dimensions dans le plan inférieures à 500 nm, de préférence inférieures à 100 nm, et de manière davantage préférée inférieures à 10 nm.

13. Procédé selon l'une quelconque des revendications précédentes, dans lequel ledit deuxième matériau (3) est du dioxyde de silicium (SiO₂).

14. Procédé selon l'une quelconque des revendications précédentes, dans lequel ledit matériau de première couche (2) est du carbure de silicium (SiC).

15. Procédé selon l'une quelconque des revendications précédentes, dans lequel ladite deuxième substance ou composition de gravure est un plasma de gravure sèche comprenant de l'O₂.

16. Procédé selon la revendication 15, dans lequel ledit plasma comprenant de l'O₂ comprend en outre au moins un composé d'hydrofluorocarbone.

17. Procédé selon la revendication 16, dans lequel ledit composé d'hydrofluorocarbone est sélectionné dans le groupe consistant en CF₄, CHF₃ et C₄F₈.

18. Procédé selon l'une quelconque des revendications précédentes, dans lequel ladite première substance ou composition de gravure comprend de l'acide fluorhydrique (HF).

19. Procédé selon l'une quelconque des revendications précédentes, dans lequel ladite première substance ou composition de gravure consiste en une solution à 49 % en poids d'HF.

20. Procédé selon la revendication 18, dans lequel l'HF est une vapeur d'HF.

21. Procédé selon l'une quelconque des revendications précédentes, dans lequel ladite pile de couches est une pile à damasquinage simple ou double.

22. Procédé selon l'une quelconque des revendications précédentes, dans lequel ledit procédé est effectué lors du traitement BEOL (Back End of Line).

23. Procédé selon la revendication 11 ou l'une quelconque des revendications dépendant de la revendication 11, dans lequel ladite ligne intégrée dans la couche de base (9) et ladite ligne (1) forment un contact électrique.

24. Procédé de fabrication d'un dispositif à semi-conducteur comportant des entrefers comprenant un procédé selon l'une quelconque des revendications précédentes.

25. Procédé de fabrication d'un dispositif à semi-conducteur comportant des entrefers selon la revendication 24, dans lequel les étapes suivantes sont répétées au moins deux fois :
- l'exécution d'un procédé selon l'une quelconque des revendications précédentes, et
- la création d'une pile suivante de couches par-dessus la structure d'entrefers résultant de l'étape précédente.
